# EUROPÄISCHE PATENTSCHRIFT

(11) **EP 1 156 884 B1**
(45) Veröffentlichungstag und Bekanntmachung des Hinweises auf die Patenterteilung: **05.11.2003**
(21) Anmeldenummer: 00910554.5
(22) Anmeldetag: 25.02.2000
(51) Int. Cl.: B05C 3/20, B05C 9/02

(54) **VORRICHTUNG UND VERFAHREN ZUM AUFBRINGEN VON KLEBERMATERIAL AUF FLÄCHIGE BAUTEILE SOWIE DESSEN VERWENDUNG**
DEVICE AND METHOD FOR APPLYING ADHESIVE MATERIAL ONTO PLANAR COMPONENTS AND THE USE THEREOF
DISPOSITIF ET PROCEDE PERMETTANT D'APPLIQUER DE LA COLLE SUR DES COMPOSANTS PLATS ET SON UTILISATION

(30) Priorität: 27.02.1999 DE 19908625
(43) Veröffentlichungstag der Anmeldung: 28.11.2001
(73) Patentinhaber: Knor, Hubert, 88699 Frickingen (DE); Reiner, Marcus, 88696 Owingen (DE)
(72) Erfinder: Knor, Hubert, 88699 Frickingen (DE); Reiner, Marcus, 88696 Owingen (DE)
(74) Vertreter: Patentanwälte Eisele, Otten, Roth & Dobler
(86) Internationale Anmeldenummer: DE0000550
(87) Internationale Veröffentlichungsnummer: WO00051748

(56) Entgegenhaltungen:
- US-A- 1 493 809
- US-A- 3 003 461
- US-A- 4 346 124
- PATENT ABSTRACTS OF JAPAN vol. 1997, no. 2, 28. Februar 1997 (1997-02-28) & JP 08 252987 A (FUTABA CORP.), 1. Oktober 1996 (1996-10-01)

## Beschreibung

### Stand der Technik

Die Erfindung betrifft eine Vorrichtung und ein Verfahren zum Aufbringen von Klebermaterial auf flächige Bauteile wie Substrate, Halbleiterchips (dice) oder dergleichen sowie dessen Verwendung.

In der Aufbau- und Verbindungstechnik elektronischer Baugruppen werden die für die Verbindung notwendigen Medien, zum Beispiel isotrope oder anisotrope Kleber, häufig mit Hilfe von Siebdruckverfahren oder Dispensverfahren auf Substratoberflächen oder dergleichen aufgebracht. Anschließend kann eine Bestückung mit gewünschten Bauteilen, Halbleiterchips oder anderen elektronischen Baugruppen erfolgen.

Siebdruckverfahren haben dabei den Nachteil, daß der Kleberauftrag nur mit aufwendigen Werkzeugen beherrschbar ist, die umfangreiche Einricht- und Inbetriebnahmezeiten erfordern. Dabei ist ein erwünschtes gleichmäßiges Druckbild mit gleichbleibendem Klebermaterialtransport durch das Sieb während vieler Druckzyklen nur schwer zu erreichen, da leicht veränderbare physikalische Eigenschaften des Klebermaterials, wie zum Beispiel seine Viskosität unmittelbar darauf Einfluß nehmen.

Die Dispenstechnik von Klebematerial erfordert vor allem eine nur mit Aufwand zu erreichende exakte Einstellung im Hinblick auf die zu dispensende Klebermaterialmenge bzw. die Positionierung eines Dispenswerkzeuges, wie z. B. einer Dispensnadel. Im Weiteren kann insbesondere eine ungleichmäßige Verdrängung des aufgebrachten Klebermaterials beim Aufbringen des Bauteils zu Problemen führen, wenn zum Beispiel für den weiteren Prozeß erforderliche Bond-Pads durch Klebermaterial überdeckt werden.

Außerdem sind diese bekannten Klebeverfahren für die Chip on Chipmontage kaum oder gar nicht geeignet.

In der US-Patentschrift US 4,346,124 wird ein Chip-"coater" beschrieben, der einen Klebermaterialbehälter umfasst. Über der Klebermaterialoberfläche ist ein Siebelement angeordnet, das durch eine Art Höhenpaddel an einer Stelle in das Klebermaterial gedrückt wird, um Klebermaterial aufzunehmen. Dies erfolgt dadurch, dass sich das runde Sieb unter dem Paddel durchdreht. An einer vom Paddel entfernteren Stelle, an welcher das Sieb über der Klebermaterialoberfläche angeordnet ist, wird der zu benetzende Chip mittels eines "vacuum-chuck" aufgesetzt. Diese Vorrichtung ist jedoch nicht nur aufwendig herzustellen, sondern erfordert auch vor dem Einsatz einen zeitaufwendigen Justierprozess.

### Aufgabe und Vorteile der Erfindung

Der Erfindung liegt die Aufgabe zugrunde, die zu verklebenden Oberflächen von flächigen Bauteilen, wie Substrate, Halbleiterchips oder dergleichen mit einem gleichmäßigen in der Dicke leicht kontrollierbaren Kleberauftrag zu versehen, wobei sich insbesondere die oben beschriebenen Nachteile des Standes der Technik vermeiden lassen und eine Chip on Chip-Montage ermöglicht wird.

Diese Aufgabe wird durch die Merkmale des Anspruchs 1 sowie der Ansprüche 2 und 10 gelöst. In den Unteransprüchen sind vorteilhafte und zweckmäßige Weiterbildungen der Erfindung angegeben.

Ausgangspunkt der Erfindung ist zunächst eine Vorrichtung zum Aufbringen von Klebermaterial auf flächige Bauteile, wie Substrate, Halbleiterchips oder dergleichen mit einem Kleberbett und einem im Bereich der Kleberbettoberfläche angeordneten Siebelement, dessen Öffnungen ein Hindurchtreten von Klebermaterial erlauben. Der Kern der Erfindung liegt nun darin, daß das Kleberbett auf einer Grundplatte angeordnet ist und aus Klebermaterial besteht und daß die Dicke des Kleberbettes im Bereich der Dicke des Siebelementes liegt. Auf diese Weise läßt sich der Klebermengenauftrag und insbesondere die Kleberdicke einfach und sicher kontrollieren, wobei eine Veränderung von physikalischen Eigenschaften des Klebermaterials, wie zum Beispiel seine Viskosität, während des Prozesses den Kleberauftrag im Wesentlichen nicht beeinträchtigen. Denn durch diese Maßnahme kann das Siebelement nur soweit in das Kleberbett eindringen, bis es auf der Kleberbettunterlage aufsitzt. Damit wird auf jeden Fall gewährleistet, daß nicht zu viel Klebermaterial durch das Siebelement hindurchtritt. Vorteilhafterweise ist die Dicke des Kleberbettes etwas größer als die Dicke des Siebelements. Außerdem ist es günstig, wenn das Siebelement über dem Kleberbett in dessen Oberflächenbereich angeordnet ist.

In einer alternativen oder zusätzlichen Ausgestaltung der Erfindung ist es zur einfachen Kontrolle des Eintauchverhaltens des Siebelements in das Kleberbett ebenfalls bevorzugt, wenn das Kleberbett auf einer Grundplatte angeordnet ist und aus Klebermaterial besteht und wenn das Siebelement an der Aufsetzstelle eines Bauteils im Kleberbett in dessen Oberflächenbereich angeordnet ist. Vorzugsweise gibt das Siebelement elastisch nach.

Der Kleberauftrag kann von Eigenschaften des Siebelements, zum Beispiel die Fläche der Öffnungen für den Kleberdurchgang, bestimmt werden. Für einen gleichmäßigen Kleberauftrag ist es bevorzugt, wenn die Öffnungen wesentlich kleiner sind als die Auflagefläche der zu benetzenden Bauteile. Ist die Fläche der Öffnungen im Vergleich zur geschlossenen Fläche des Siebelements groß, wird die Bauteiloberflächenseite stärker benetzt werden als bei einer kleinen Gesamtfläche von gleichmäßig verteilten Öffnungen.

In einer besonders vorteilhaften Ausführungsform der Erfindung umfaßt das Siebelement ein Maschengewebe. Maschengewebe sind in unterschiedlichen Maschenweiten bzw. Fadenstärken erhältlich, da sie im Siebdruckverfahren regelmäßig eingesetzt werden.

Insbesondere um Halbleiterchips miteinander zu verkleben, das heißt zum Beispiel einen kleineren Halbleiterchip auf einen größeren Halbleiterchip aufzusetzen, ist es vorteilhaft, wenn die Maschenweite im Bereich von 25 - 150 µm liegt bzw. wenn die Fadenstärke des Gewebes im Bereich von 10 - 80 µm liegt.

Außerdem ist es bevorzugt, wenn das Kleberbett auf einer Grundplatte angeordnet ist, deren Oberflächenbeschaffenheit derart ausgebildet ist, daß das Klebermaterial nicht in ungünstiger Weise an der Oberfläche der Grundplatte haften bleibt. Durch diese Maßnahme soll erreicht werden, daß nicht ein Großteil des die Oberfläche von Bauteilen benetzenden Klebermaterials für z. B. den Fall, daß ein im Kleberbett angeordnetes Siebelement mit darauf aufgesetzten Bauteilen komplett abgehoben wird, bei diesem Vorgang an der Grundplatte zurückbleibt, sondern in ausreichendem Maße mit dem Siebelement und den aufgesetzten Bauteilen entfernt werden kann.

Ein erfindungsgemäßes Verfahren zum Aufbringen von Klebermaterial auf flächige Bauteile, wie Substrate, Halbleiterchips oder dergleichen zeichnet sich dadurch aus, daß das Klebermaterial als flächiges Kleberbett auf einer Grundplatte bereitgestellt wird und daß im Kleberbett ein Siebelement angeordnet wird, dessen Öffnungen ein Hindurchtreten von Klebermaterial erlauben, so daß auf die Oberfläche des Siebelements Klebermaterial transportiert wird, das auf der Oberfläche des Siebelements befindliche Bauteile an deren Auflageoberfläche benetzt oder die Auflageoberfläche von Bauteilen benetzt, die auf das Siebelement aufgesetzt werden. D. h. im ersten Fall wird z. B. das Siebelement mit bereits aufgesetzten Bauteilen im Kleberbett positioniert, während im zweiten Fall die Bauteile aufgesetzt werden, wenn das Siebelement sich bereits im Kleberbett befindet. In beiden Fällen können die Bauteile samt Siebelement zur Weiterverarbeitung abgehoben werden.

Um das Verfahren einfach zu gestalten, wird vorgeschlagen, daß das Kleberbett mittels eines Schablonendrucks, einer Rackeleinrichtung oder dergleichen erzeugt wird.

Zur einfachen Kontrolle des Aufsetzvorgangs von Bauteilen wird überdies vorgeschlagen, daß die Bauteile mit einem "Pick Tool", wie einer Vakuumpinzette auf das Siebelement aufgesetzt und wieder abgehoben werden.

Um zu vermeiden, daß eine zu große Menge Klebermaterial durch das Siebelement auf die Siebelementoberfläche gelangt, wird im Weiteren vorgeschlagen, daß das Siebelement nicht wesentlich weiter als die Dicke des Siebelements in das Kleberbett gedrückt wird bzw. in diesem angeordnet wird.

Zur Einstellung der Dicke des Kleberauftrags wird im Weiteren vorgeschlagen, daß die Dicke des Kleberauftrags durch das Verhältnis der Öffnungsflächen zur geschlossenen Fläche am Siebelement bestimmt wird.

Vorzugsweise wird dieses Verfahren dazu eingesetzt, wie bereits oben für die Vorrichtung beschrieben, Halbleiterchips miteinander zu verkleben. Durch den gleichmäßig dünnen Kleberauftrag, der sich durch die Erfindung erzielen läßt, bildet sich beim Aufeinanderkleben von Halbleiterchip im Randbereich ein nur kleiner Quellwulst, so daß im Umfeld angeordnete Bereiche im Wesentlichen nicht beeinträchtigt werden. Das heißt beispielsweise werden keine Bondpads mit Klebermaterial überdeckt, die für eine Kontaktierung eines aufgesetzten Halbleiterchips mit dem darunter liegenden Halbleiterchip noch benötigt werden.

Das Verfahren kann jedoch auch dazu eingesetzt werden, pastöse oder viskose Verbindungsmedien oder Stoffe, wie z. B. Lötpaste, aufzubringen.

### Zeichnungen

Die Erfindung ist in den folgenden Zeichnungen unter Nennung von weiteren Vorteilen und Einzelheiten näher erläutert.

Figur 1a bis b zeigen den Aufbringvorgang von Klebermaterial auf eine Oberflächenseite eines Halbleiterchips in unterschiedlichen Stadien in einer teilweise geschnittenen Seitenansicht.

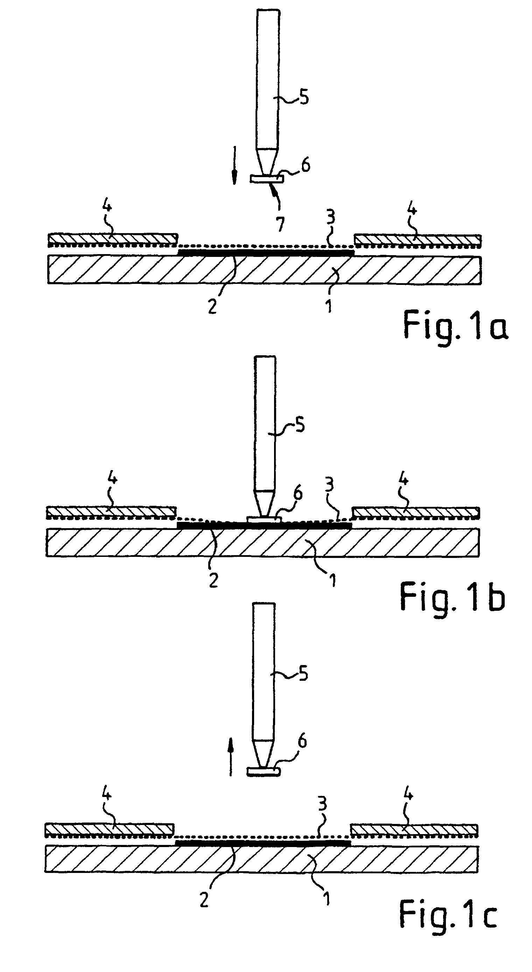

Die Vorrichtung zum Aufbringen von Klebermaterial auf flächige Bauteile umfaßt eine Grundplatte 1, auf welcher beispielsweise durch einen Schablonendruck ein Kleberbett 2 mit einer gleichmäßig flächig verteilten Klebermenge aufgebracht wurde. Unmittelbar über der Grundplatte und dem Kleberbett in geringem Abstand dazu ist ein Maschengewebe 3 angeordnet. Das Maschengewebe 3 ist beispielhaft auf einen Rahmen 4 aufgespannt. Über den Rahmen 4 ist das Maschengewebe in Bezug auf das Kleberbett 2 derart positioniert, daß das Maschengewebe 3 im Wesentlichen nicht in das Kleberbett 2 eintaucht (siehe Figur 1a bzw. Figur 1c).

Das Aufbringen von Klebermaterial auf eine Oberflächenseite eines Halbleiterchips zum Verkleben mit einem weiteren Halbleiterchip kann sich nun wie folgt gestalten:
1. Mittels eines "Picktool" 5 (z. B. eine Vakuumpinzette) wird ein Bauteil, zum Beispiel ein Halbleiterchip 6 auf dem Maschengewebe 3 in Pfeilrichtung aufgesetzt (siehe Figur 1a und Figur 1b). Dabei taucht das Maschengewebe 3 in das Kleberbett 2 ein, so daß Klebermaterial durch die Öffnungen des Maschengewebes in Richtung Halbleiterchip gepreßt wird und somit dessen aufliegende Oberfläche benetzt wird. Durch den Kontakt der zu verklebenden Halbleiterchip-Auflagefläche 7 mit dem Maschengewebe 3 kann nur eine ganz bestimmte Menge an Klebermaterial zur Halbleiterchip-Auflagefläche 7 gelangen.
2. Nach erfolgter Benetzung der Halbleiter-Auflagefläche 7 mit Klebermaterial des Kleberbetts 2 wird anschließend der Halbleiterchip 6 mit der Vakuumpinzette 5 vom Maschengewebe 3 in Pfeilrichtung abgehoben (siehe Figur 1c) und kann nunmehr mit einem vorbereiteten weiteren Chip verklebt werden, in dem der Halbleiterchip 6 einfach auf die vorgesehene Stelle des Halbleiterchips (nicht gezeigt) aufgesetzt wird.

Durch die erfindungsgemäße Vorgehensweise läßt sich mit geringem konstruktivem Aufwand ein gleichmäßig dünner Kleberauftrag mit gleichbleibender Qualität erzielen, wobei insbesondere leicht veränderbare Klebermaterialeigenschaften diesen Vorgang nicht beeinflussen.

Bezugszeichenliste:
- 1: Grundplatte
- 2: Kleberbett
- 3: Maschengewebe
- 4: Rahmen
- 5: Vakuumpinzette
- 6: Halbleiterchip
- 7: Halbleiterchip-Auflagefläche

## Patentansprüche

1. Vorrichtung zum Aufbringen von Klebermaterial auf flächige Bauteile wie Substrate, Halbleiterchips oder dergleichen, mit einem Kleberbett (2) und einem im Bereich der Kleberbettoberfläche angeordneten Siebelement (3), dessen Öffnungen ein Hindurchtreten von Klebermaterial erlauben, **dadurch gekennzeichnet, daß** das Kleberbett auf einer Grundplatte angeordnet ist und aus Klebermaterial besteht und daß die Dicke des Kleberbettes im Bereich der Dicke des Siebelements liegt.

2. Vorrichtung zum Aufbringen von Klebermaterial auf flächige Bauteile wie Substrate, Halbleiterchips oder dergleichen, mit einem Kleberbett (2) und einem im Bereich der Kleberbettoberfläche angeordneten Siebelement (3), dessen Öffnungen ein Hindurchtreten von Klebermaterial erlauben, insbesondere nach Anspruch 1, **dadurch gekennzeichnet, daß** das Kleberbett auf einer Grundplatte angeordnet ist und aus Klebermaterial besteht und daß das Siebelement (3) an der Aufsetzstelle eines Bauteils im Kleberbett in dessen Oberflächenbereich angeordnet ist.

3. Vorrichtung nach Anspruch 1 oder 2, **dadurch gekennzeichnet, daß** die Öffnungen im Siebelement wesentlich kleiner sind, als die Auflagefläche (7) des zu benetzenden flächigen Bauteils (6).

4. Vorrichtung nach einem der vorhergehenden Ansprüche, **dadurch gekennzeichnet, daß** das Siebelement elastisch nachgiebig ist.

5. Vorrichtung nach einem der vorhergehenden Ansprüche, **dadurch gekennzeichnet, daß** das Siebelement ein Maschengewebe (3) umfaßt.

6. Vorrichtung nach Anspruch 5, **dadurch gekennzeichnet, daß** die Maschenweite im Bereich von 25 - 150 µm liegt.

7. Vorrichtung nach Anspruch 5 oder 6, **dadurch gekennzeichnet, daß** die Fadenstärke des Gewebes im Bereich von 10 - 60 µm liegt.

8. Vorrichtung nach einem der vorhergehenden Ansprüche, **dadurch gekennzeichnet, daß** das Kleberbett auf einer Grundplatte angeordnet ist, deren Oberflächenbeschaffenheit derart ausgebildet ist, daß das Klebermaterial nicht in ungünstiger Weise an der Oberfläche der Grundplatte haftet.

9. Verfahren zum Aufbringen von Klebermaterial auf flächige Bauteile, wie Substrate, Halbleiterchips oder dergleichen, wobei das Klebermaterial als flächiges Kleberbett (2) auf einer Grundplatte bereitgestellt wird und im Kleberbett ein Siebelement (3) angeordnet wird, dessen Öffnungen ein Hindurchtreten von Klebermaterial erlauben, so daß auf die Oberfläche des Siebelements Klebermaterial transportiert wird, das auf der Oberfläche des Siebelements (3) befindliche Bauteile an deren Auflagefläche benetzt oder die Auflagefläche von Bauteilen benetzt, die auf das Siebelement (3) aufgesetzt werden.

10. Verfahren nach Anspruch 9, **dadurch gekennzeichnet, daß** das Kleberbett (2) mittels eines Schablonendrucks, einer Rackeleinrichtung oder dergleichen erzeugt wird.

11. Verfahren nach einem der Ansprüche 9 bis 10, **dadurch gekennzeichnet, daß** das Bauelement (6) mit einem "Pick Tool", wie zum Beispiel einer Vakuumpinzette, auf das Siebelement (3) aufgesetzt und wieder abgehoben wird.

12. Verfahren nach einem der Ansprüche 9 bis 11, **dadurch gekennzeichnet, daß** das Siebelement nicht wesentlich weiter als die Dicke des Siebelements in das Kleberbett gedrückt wird bzw. in diesem angeordnet wird.

13. Verfahren nach einem der Ansprüche 9 bis 12, **dadurch gekennzeichnet, daß** die Dicke des Kleberauftrags durch das Verhältnis der Öffnungsflächen zur geschlossenen Fläche am Siebelement (3) bestimmt wird.

14. Verwendung des Verfahrens nach einem der Ansprüche 9 bis 13 zum Aufkleben und Aufeinanderkleben von Halbleiterchips.

15. Verwendung des Verfahrens nach einem der Ansprüche 9 bis 13 zum Aufbringen von pastösen oder viskosen Verbindungsmedien oder Stoffen.

## Claims

1. Device for applying adhesive material onto planar components such as substrates, semiconductor chips or the like, comprising an adhesive bed (2) and a screening element (3) arranged in the region of the surface of the adhesive bed, the openings of which screening element (3) allow passage of adhesive material, **characterised in that** the adhesive bed is arranged on a base plate and consists of adhesive material, and **in that** the thickness of the adhesive bed is in the range of the thickness of the screening element.

2. Device for applying adhesive material onto planar components such as substrates, semiconductor chips or the like, comprising an adhesive bed (2) and a screening element (3) arranged in the region of the surface of the adhesive bed, the openings of which screening element (3) allow passage of adhesive material, in particular, according to claim 1, **characterised in that** the adhesive bed is arranged on a base plate and consists of adhesive material, and **in that** the screening element (3) is arranged at the setting-down place of a component in the adhesive bed and in the surface region thereof.

3. Device according to claim 1 or 2, **characterised in that** the openings in the screening element are substantially smaller than the supporting face (7) of the planar component (6) to be wetted.

4. Device according to any of the preceding claims, **characterised in that** the screening element is elastic.

5. Device according to any of the preceding claims, **characterised in that** the screening element comprises a meshed fabric (3).

6. Device according to claim 5, **characterised in that** the mesh width is in the range of 25 to 150 µm.

7. Device according to claim 5 or 6, **characterised in that** the yarn thickness of the fabric is in the range of 10 to 60 µm.

8. Device according to any of the preceding claims, **characterised in that** the adhesive bed is arranged on a base plate, of which the surface make-up is constructed in such a way that the adhesive material does not disadvantageously adhere to the surface of the base plate.

9. Method for applying adhesive material onto planar components, such as substrates, semiconductor chips or the like, wherein the adhesive material is provided as a planar adhesive bed (2) on a base plate and a screening element (3) is arranged in the adhesive bed, the openings of which screening element (3) allow passage of adhesive material, so adhesive material is conveyed on the surface of the screening element and wets components located onto the surface of the screening element (3) on their supporting face or wets the supporting face of components which are placed on the screening element (3).

10. Method according to claim 9, **characterised in that** the adhesive bed (2) is produced by means of screen printing, a doctor blade device or the like.

11. Method according to either of claims 9 or 10, **characterised in that** the component (6) is placed on the screening element (3) and lifted off again using a "pick tool", such as vacuum forceps.

12. Method according to any of claims 9 to 11, **characterised in that** the screening element is not substantially pressed further than the thickness of the screening element into the adhesive bed or arranged therein.

13. Method according to any of claims 9 to 12, **characterised in that** the thickness of the adhesive application is determined by the ratio of the opening faces to the closed face on the screening element (3).

14. Use of the method according to any of claims 9 to 13 for gluing semiconductor chips and gluing semiconductor chips to one another.

15. Use of the method according to any of claims 9 to 13 for applying pasty or viscose joining media or materials.

## Revendications

1. Dispositif pour appliquer de la colle sur des pièces plates, comme des substrats, des puces semi-conductrices ou analogues, comportant un lit de colle (2) et un élément de tamis (3) agencé dans la zone de la surface du lit de colle, dont les ouvertures permettent une traversée de la colle,
**caractérisé en ce que** le lit de colle est agencé sur une plaque de base et est constitué de colle, et **en ce que** l'épaisseur du lit de colle se trouve dans la plage de l'épaisseur de l'élément de tamis.

2. Dispositif pour appliquer de la colle sur des pièces plates, comme des substrats, des puces semi-conductrices ou analogues, comportant un lit de colle (2) et un élément de tamis (3) agencé dans la zone de la surface du lit de colle, dont les ouvertures permettent une traversée de la colle, en particulier selon la revendication 1,
**caractérisé en ce que** le lit de colle est agencé sur une plaque de base et est constitué de colle, et **en ce que** l'élément de tamis (3) est agencé à l'emplacement de pose d'une pièce dans le lit de colle sur sa zone de surface.

3. Dispositif selon la revendication 1 ou 2,
**caractérisé en ce que** les ouvertures dans l'élément de tamis sont sensiblement plus petites que la surface d'appui (7) de la pièce plate (6) à humecter.

4. Dispositif selon une des revendications précédentes,
**caractérisé en ce que** l'élément de tamis est élastiquement souple.

5. Dispositif selon une des revendications précédentes,
**caractérisé en ce que** l'élément de tamis comporte un tissu à mailles (3).

6. Dispositif selon la revendication 5,
**caractérisé en ce que** la largeur de maille vaut dans la plage de 25 - 150 µm.

7. Dispositif selon la revendication 5 ou 6,
**caractérisé en ce que** l'épaisseur de fil du tissu vaut dans la plage de 10 - 60 µm.

8. Dispositif selon une des revendications précédentes,
**caractérisé en ce que** le lit de colle est agencé sur une plaque de base, dont la structure de surface est telle que la colle n'adhère pas, de façon inappropriée, à la surface de la plaque de base.

9. Procédé pour appliquer de la colle sur des pièces plates, comme des substrats, des puces semi-conductrices ou analogues, la colle étant disponible comme lit de colle plat (2) sur une plaque de base et, dans le lit de colle, un élément de tamis (3) étant agencé, dont les ouvertures permettent une traversée de la colle, de sorte que de la colle est transportée sur la surface de l'élément de tamis, laquelle humecte des pièces se trouvant sur la surface de l'élément de tamis (3) sur sa surface d'appui ou humecte la surface d'appui de pièces qui sont posées sur l'élément de tamis (3).

10. Procédé selon la revendication 9,
**caractérisé en ce que** le lit de colle (2) est engendré au moyen d'une pression de gabarit, d'un dispositif à racle ou analogue.

11. Procédé selon une des revendications 9 à 10,
**caractérisé en ce que** la pièce (6) est posée sur l'élément de tamis (3) et à nouveau soulevée au moyen d'un "pick tool", comme par exemple une pince sous vide.

12. Procédé selon une des revendications 9 à 11,
**caractérisé en ce que** l'élément de tamis est pressé dans le lit de colle ou est agencé dans celui-ci de façon pas beaucoup plus importante que l'épaisseur de l'élément de tamis.

13. Procédé selon une des revendications 9 à 12,
**caractérisé en ce que** l'épaisseur de l'application de colle est déterminée par le rapport des surfaces d'ouvertures par rapport à la surface fermée sur l'élément de tamis (3).

14. Utilisation du procédé selon une des revendications 9 à 13, pour coller et coller l'une sur l'autre des puces semi-conductrices.

15. Utilisation du procédé selon une des revendications 9 à 13, pour appliquer des matières ou agents de liaison visqueux ou pâteux.
